# EUROPEAN PATENT APPLICATION

(11) **EP 4 726 422 A2**
(43) Date of publication of application: **15.04.2026**
(21) Application number: 25745387.8
(22) Date of filing: 24.01.2025
(51) Int. Cl.: G01R 31/396, G01R 35/00, G01R 31/382, G01R 19/30, G01R 19/165, B60L 58/10

(54) **APPARATUS AND METHOD FOR DIAGNOSING BATTERY**

(30) Priority: 26.01.2024 KR 20240012287
(71) Applicant: LG Energy Solution, Ltd., Seoul 07335 (KR)
(72) Inventor: CHOI, Soon-Hyung, Daejeon 34122 (KR); KIM, Dong-Hyun, Daejeon 34122 (KR); KIM, Young-Deok, Daejeon 34122 (KR)
(74) Representative: Goddar, Heinz J.
(86) International application number: PCT/KR2025/001462
(87) International publication number: WO 2025/159565

(57) **Abstract**

A battery diagnosing apparatus according to an embodiment of the present disclosure includes: a profile acquisition unit that acquires a differential profile representing a correspondence between a capacity and a differential voltage of a battery; a profile correction unit that determines a target C-rate (current rate) corresponding to the differential profile, and corrects the differential profile based on an overvoltage profile corresponding to the target C-rate, thereby generating a corrected profile; and a control unit that diagnoses a state of the battery based on a shape of a target capacity section of the corrected profile.

## Description

### TECHNICAL FIELD

This application is based on and claims priority from Korean Patent Application No. 10-2024-0012287, filed on January 26, 2024, with the Korean Intellectual Property Office, the disclosure of which is incorporated herein in its entirety by reference.

The present disclosure relates to a battery diagnosing apparatus and method, more particularly, an apparatus and method for diagnosing the state of a battery.

### BACKGROUND

Recently, with the rapidly increasing demand for portable electronics such as notebook computers, video cameras, and portable telephones, and the accelerating development of electric vehicles, energy storage batteries, robots, and satellites, researches on the high-performance batteries allowing repeated charging and discharging are actively underway.

Currently, commercially available batteries include, for example, nickel-cadmium batteries, nickel-hydrogen batteries, nickel-zinc batteries, and lithium batteries. Of these batteries, lithium batteries are gaining considerable attention due to their advantages including a substantially low memory effect to allow a high degree of freedom in charging and discharging, a very low self-discharging rate, and high energy density, as compared to nickel-based batteries.

While many studies are being conducted on the batteries focusing on the high-capacity and the high-density, it is also important to improve the lifespan and the safety of the batteries. In order to enhance the safety of batteries, a technology is necessary, which may accurately diagnose the current state of batteries.

### DISCLOSURE

### Technical Problem

The present disclosure provides a battery diagnosing apparatus and method, which may diagnose the current state of a battery.

Various aspects of the present disclosure may be understood from the descriptions herein below, and may be more clearly understood from embodiments of the present disclosure. Further, it is readily apparent that various aspects of the present disclosure may be implemented by elements described in the claims and combinations thereof.

### Technical Solution

A battery diagnosing apparatus according to an aspect of the present disclosure may include: a profile acquisition unit that acquires a differential profile representing a correspondence between a capacity and a differential voltage of a battery; a profile correction unit that determines a target C-rate (current rate) corresponding to the differential profile, and corrects the differential profile based on an overvoltage profile corresponding to the target C-rate, thereby generating a corrected profile; and a control unit that diagnoses a state of the battery based on a shape of a target capacity section of the corrected profile.

The control unit may be configured to determine, as a target peak, a minimum point with a smallest corresponding capacity among a plurality of minimum points included in the corrected profile, and set the target capacity section based on a target differential voltage corresponding to the target peak.

The control unit may be configured to determine a reference point corresponding to the target differential voltage and closest to the target peak in the corrected profile, and set a capacity section from the target peak to the reference point as the target capacity section TR.

The control unit may be configured such that when a differential capacity of the target peak is smaller than a differential capacity of a second minimum point with a second smallest corresponding capacity among the plurality of minimum points, a differential voltage corresponding to the second minimum point is set as the target differential voltage.

The control unit may be configured to determine a reference point corresponding to the target differential voltage and closest to the second minimum point in the corrected profile, and set a capacity section from the reference point to the second minimum point as the target capacity section.

The control unit may be configured to divide the target capacity section into a low capacity section and a high capacity section, and diagnose the state of the battery based on a section including a feature point with a largest corresponding differential voltage in the target capacity section.

The control unit may be configured such that when the feature point is included in the high capacity section, the state of the battery is diagnosed as an available lithium loss state.

The profile correction unit may be configured to calculate a difference between the differential profile and the overvoltage profile to generate the corrected profile.

The overvoltage profile is configured to be pre-stored for each of a plurality of C-rates.

The profile correction unit may be configured to select the overvoltage profile corresponding to the target C-rate from a plurality of pre-stored overvoltage profiles.

The overvoltage profile may be preset based on a reference differential profile of a reference battery for a reference C-rate and a target differential profile of the reference battery for the target C-rate.

The battery diagnosing apparatus according to claim 10, wherein the overvoltage profile may be preset to represent a difference between the reference differential profile and the target differential profile.

A battery pack according to another aspect of the present disclosure may include the battery diagnosing apparatus according to an aspect of the present disclosure.

A vehicle according to yet another aspect of the present disclosure may include the battery diagnosing apparatus according to an aspect of the present disclosure.

A battery diagnosing method according to still yet another aspect of the present disclosure may include: a profile acquisition step of acquiring a differential profile representing a correspondence between a capacity and a differential voltage of a battery; a target determination step of determining a target C-rate corresponding to the differential profile; a corrected profile generation step of correcting the differential profile based on an overvoltage profile corresponding to the target C-rate to generate a corrected profile; and a battery diagnosis step of diagnosing a state of the battery based on a shape of a target capacity section of the corrected profile.

A non-transitory computer-readable storage medium according to still yet another aspect of the present disclosure may store therein a program for performing a battery diagnosing method including: a profile acquisition step of acquiring a differential profile representing a correspondence between a capacity and a differential voltage of a battery; a target determination step of determining a target C-rate corresponding to the differential profile; a corrected profile generation step of correcting the differential profile based on an overvoltage profile corresponding to the target C-rate to generate a corrected profile; and a battery diagnosis step of diagnosing a state of the battery based on a shape of a target capacity section of the corrected profile.

### Advantageous Effects

According to an aspect of the present disclosure, the state of a battery is diagnosed from a corrected profile, so that the state of the battery may be diagnosed relatively quickly.

The effects of the present disclosure are not limited to those described above, and other effects that are not described herein may clearly be understood to those skilled in the art from the descriptions in the claims.

### BRIEF DESCRIPTION OF THE DRAWINGS

Since the drawings attached herewith serve to facilitate the understanding of the technical idea of the present disclosure in conjunction with the detailed description of the invention herein below, the present disclosure should not be construed as being limited to the matters illustrated in the drawings.
FIG. 1 is a view schematically illustrating a battery diagnosing apparatus according to an embodiment of the present disclosure.
FIG. 2 is a view schematically illustrating a battery profile according to an embodiment of the present disclosure.
FIG. 3 is a view schematically illustrating a differential profile according to an embodiment of the present disclosure.
FIG. 4 is a view schematically illustrating a differential profile and a corrected profile according to an embodiment of the present disclosure.
FIG. 5 is a view schematically illustrating a corrected profile according to an embodiment of the present disclosure.
FIG. 6 is a view schematically illustrating a plurality of corrected profiles for a first battery according to an embodiment of the present disclosure.
FIG. 7 is a view schematically illustrating the state of a battery corresponding to a plurality of corrected profiles for a second battery according to an embodiment of the present disclosure.
FIG. 8 is a view schematically illustrating a battery pack according to another embodiment of the present disclosure.
FIG. 9 is a view schematically illustrating a vehicle according to yet another embodiment of the present disclosure.
FIG. 10 is a view schematically illustrating a battery diagnosing method according to still yet another embodiment of the present disclosure.

### DETAILED DESCRIPTION

Words and terms used in the detailed description and the claims herein should not be interpreted to be limited to their usual or dictionary meanings, but should be interpreted to have meanings and concepts that correspond to the technical idea of the present disclosure in compliance with the principle that inventors may appropriately define terms and concepts for the purpose of best describing the present disclosure.

Accordingly, it can be appreciated that the embodiments described herein and the configurations illustrated in the drawings are merely examples of the present disclosure, which do not exhaustively represent the technical idea of the present disclosure, and various equivalents and modifications may be made to substitute the present disclosure at the time of filing the present disclosure.

When describing the present disclosure, detailed description of related known configurations or functions may be omitted if determined to obscure the gist of the present disclosure.

Terms with ordinal numbers such as first, second and so on may be used to discriminate one of various components from the other, but should not be interpreted as limiting the components.

Throughout the descriptions herein, when a certain part "includes" a specific component, this description does not indicate that the certain part excludes other components, but indicates that the certain part may further include other components, unless otherwise defined.

Further, throughout the descriptions herein, when two components are "connected" to each other, this description indicates not only that the two components are "directly connected" to each other, but also that the two components are "indirectly connected" to each other via another component.

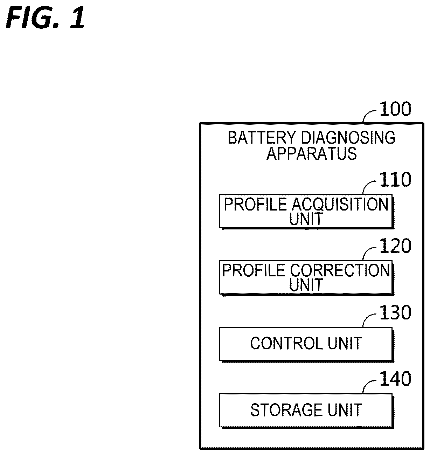

FIG. 1 is a view schematically illustrating a battery diagnosing apparatus 100 according to an embodiment of the present disclosure.

Referring to FIG. 1, the battery diagnosing apparatus 100 may include a profile acquisition unit 110, a profile correction unit 120, a control unit 130, and a storage unit 140.

A battery may indicate a single isolated cell that is physically separable and has a negative electrode terminal and a positive electrode terminal. For example, a lithium-ion battery or a lithium polymer battery may be considered as the battery. The type of battery may be a cylindrical type, a prismatic type, or a pouch type. Further, the battery may indicate a battery bank, a battery module, or a battery pack, in which a plurality of cells is connected to each other in series and/or in parallel. Herein below, for the convenience of description, it is assumed that the battery indicates a single isolated cell.

The profile acquisition unit 110 may be configured to acquire a differential profile DP representing a correspondence between the voltage and the differential capacity of a battery.

For example, a battery profile BP represents a correspondence between the voltage (V) and the capacity (Q) of a battery when the battery is charged from a preset charging start SOC or 0 % to a preset charging termination SOC or 100 %. In another example, the battery profile BP may represent a correspondence between the voltage (V) and the capacity (Q) of a battery when the battery is discharged from a preset discharging start SOC or 100 % to a preset discharging termination SOC or 0 %.

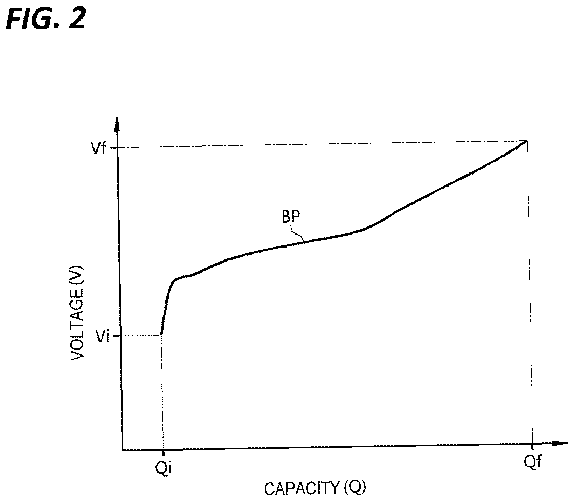

FIG. 2 is a view schematically illustrating the battery profile BP according to an embodiment of the present disclosure. In the embodiment of FIG. 2, the battery profile BP may be represented as an X-Y graph in which the X axis is set as the capacity (Q), and the Y axis is set as the voltage (V).

Then, when the battery profile BP is differentiated with respect to the capacity, a differential profile DP may be generated, which represents a correspondence between the differential voltage (dV/dQ) and the capacity (Q).

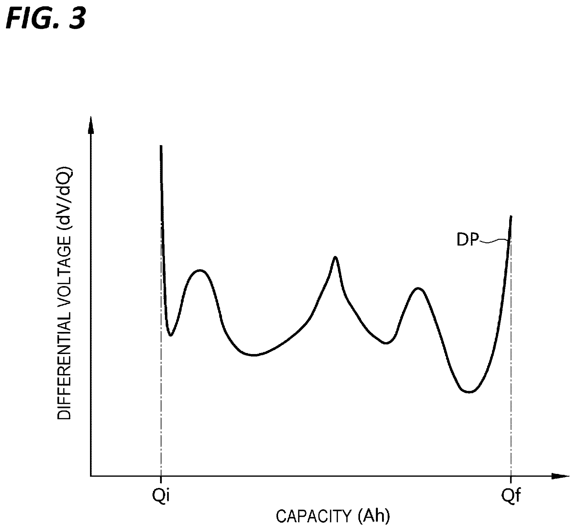

FIG. 3 is a view schematically illustrating the differential profile DP according to an embodiment of the present disclosure. In the embodiment of FIG. 3, the differential profile DP may be represented as an X-Y graph in which the X axis is set as the capacity (Q), and the Y axis is set as the differential voltage (dV/dQ).

For example, the C-rate (current-rate) of the charging or discharging for generating the battery profile BP is not particularly limited. According to an embodiment, in order to acquire more accurate battery profile BP and differential profile DP, the battery needs to be charged or discharged at a low rate. For example, the battery profile BP may be generated during the process of charging or discharging the battery at a relatively low rate such as 0.05 C.

According to an embodiment, the profile acquisition unit 110 may receive the differential profile DP of the battery directly from the outside. For example, the profile acquisition unit 110 may acquire the differential profile DP by being connected to the outside via a wired and/or wireless network to receive the differential profile DP.

In another example, the profile acquisition unit 110 may directly generate the differential profile DP by receiving the battery profile BP of the battery from the outside, and differentiating the received battery profile BP with respect to the capacity. According to an embodiment, the profile acquisition unit 110 may be connected to the outside in the wired and/or wireless manner to receive the battery profile BP, and directly generate the differential profile DP from the received battery profile BP, to acquire the differential profile DP.

In another example, the profile acquisition unit 110 may receive battery information about the voltage and the capacity of the battery from the outside, directly generate the battery profile BP based on the received battery information, and directly generate the differential profile DP based on the generated battery profile BP.

According to an embodiment, the profile acquisition unit 110 may be connected to the control unit 130 for a communication. For example, the profile acquisition unit 110 may be connected to the control unit 130 in the wired or wireless manner. The profile acquisition unit 110 may transmit the acquired differential profile DP to the control unit 130.

According to an embodiment, the profile correction unit 120 may be configured to determine a target C-rate corresponding to the differential profile DP.

According to an embodiment, the profile correction unit 120 may acquire the differential profile DP and information about the corresponding target C-rate together.

For example, when the battery is charged at 0.33 C, the target C-rate corresponding to the differential profile DP may be 0.33 C. The profile correction unit 120 may receive the differential profile DP and information about 0.33 C from the profile acquisition unit 110. Then, the profile correction unit 120 may determine 0.33 C corresponding to the differential profile DP to be the target C-rate.

The profile correction unit 120 may be configured to correct the differential profile DP based on an overvoltage profile corresponding to the target C-rate, and generate a corrected profile CP.

According to an embodiment, the overvoltage profile may be preset to represent an overvoltage portion included in the differential profile DP. For example, the overvoltage profile OP may be preset based on a reference differential profile DP of a reference battery for a reference C-rate and a target differential profile DP of the reference battery for the target C-rate. According to an embodiment, the target C-rate may be set to be greater than the reference C-rate. Further, the overvoltage profile may be preset to represent the difference between the reference differential profile DP and the target differential profile DP.

For example, in a case where the reference C-rate is 0.05 C and the target C-rate is 0.33 C, a reference battery profile BP for the reference C-rate may be acquired when the reference battery is charged (or discharged) at 0.05 C, and the reference differential profile DP may be acquired based on the reference battery profile BP. Further, when the reference battery is charged (or discharged) at 0.33 C, a target battery profile BP for the target C-rate may be acquired, and the target differential profile DP may be acquired based on the target battery profile BP. Then, an overvoltage profile corresponding to the C-rate of 0.33 C may be generated according to the difference between the reference differential profile DP and the target differential profile DP. When the battery is charged or discharged at the target C-rate greater than the reference C-rate, the measured voltage of the voltage may include an overvoltage. Thus, the profile correction unit 120 may remove the reference differential profile DP based on the reference C-rate from the target differential profile DP based on the target C-rate, thereby generating an overvoltage profile.

Then, the profile correction unit 120 may be configured to select an overvoltage profile corresponding to the target C-rate from a plurality of pre-stored overvoltage profiles.

The overvoltage profile may be stored in advance for each of a plurality of C-rates.

According to an embodiment, a plurality of overvoltage profiles may be provided, and C-rates corresponding to the plurality of overvoltage profiles, respectively, may be different from each other. For example, based on unit C-rates, overvoltage profiles corresponding to the C-rates, respectively, may be stored in advance.

Further, an overvoltage profile for a C-rate that is not acquired experimentally may be acquired and stored by an interpolation or extrapolation between similar overvoltage profiles. For example, the profile correction unit 120 may generate overvoltage profiles for various C-rates through the interpolation or extrapolation, in addition to the pre-stored overvoltage profiles, and store the generated overvoltage profiles in the storage unit 140. For example, when an overvoltage profile corresponding to the C-rate of 1 C and an overvoltage profile corresponding to the C-rate of 1.2 C are stored in advance, an overvoltage profile corresponding to the C-rate of 1.1 C may be further acquired based on the difference between the two overvoltage profiles.

The profile correction unit 120 may be configured to calculate the difference between the differential profile DP and the overvoltage profile to generate the corrected profile CP.

For example, the profile correction unit 120 may generate the corrected profile CP by calculating the difference between the differential profile DP and the overvoltage profile in the same way that the overvoltage profile is generated according to the difference between the reference differential profile DP and the target differential profile DP.

Further, the profile correction unit 120 may generate the corrected profile CP by calculating a differential capacity difference for each voltage between the differential profile DP and the overvoltage profile.

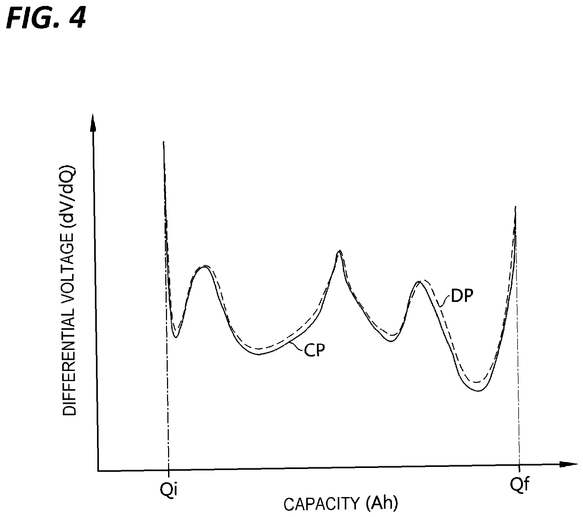

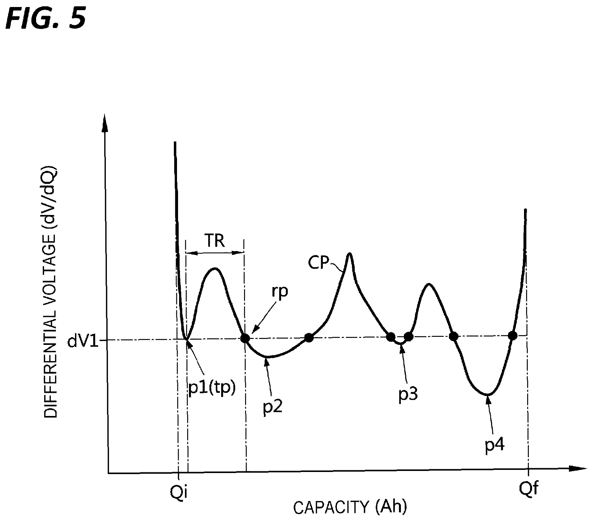

FIG. 4 is a view schematically illustrating the differential profile DP and the corrected profile CP according to an embodiment of the present disclosure. FIG. 5 is a view schematically illustrating the corrected profile CP according to an embodiment of the present disclosure.

In the embodiment of FIG. 4, the corrected profile CP may be generated according to the differential voltage difference for each capacity between the differential profile DP and a corresponding overvoltage profile (not illustrated). According to an embodiment, the profile correction unit 120 may calculate the difference between the differential profile DP and the overvoltage profile to generate the corrected profile CP in which the overvoltage portion included in the differential profile DP is removed.

The control unit 130 may be configured to diagnose the state of the battery based on the shape of a target capacity section TR of the corrected profile CP. Here, the target capacity section TR refers to a capacity section, in which which the state of the battery may be diagnosed based on the shape thereof, and an embodiment where the control unit 130 sets the target capacity section TR will be described herein later.

Referring to FIG. 5, the control unit 130 may diagnose the state of the battery based on whether the shape of the target capacity section TR has changed. For example, the control unit 130 may determine whether the shape of the target capacity section TR has changed, and diagnose the state of the battery according to the determination result.

For example, the control unit 130 may diagnose whether available lithium of the battery has been lost. For example, when it is determined that the shape of the target capacity section TR has changed, the control unit 130 may diagnose the state of the battery as an available lithium loss state.

Here, the available lithium loss state indicates a state where the amount of lithium involved in the charging and discharging of the battery has been lost as compared to the initial state due to various causes. For example, the lost lithium may precipitate as lithium metal on the negative electrode surface of the battery. This phenomenon is called a lithium plating (Li plating). When the lithium plating phenomenon becomes severe, a short circuit occurs in the battery, which may cause unexpected serious problems such as fire and explosion.

The battery diagnosing apparatus 100 according to an embodiment of the present disclosure may use an overvoltage profile to relatively quickly derive the corrected profile CP from which the state of the battery may be diagnosed. Then, the battery diagnosing apparatus 100 may diagnose the state of the battery based solely on the shape of the target capacity section TR in the corrected profile CP, so that it is possible to more quickly diagnose the state of the battery. According to the present disclosure, it is quickly diagnosed whether the available lithium of the battery has been lost, and therefore, unforeseen accidents caused by the lithium plating may be prevented or suppressed in advance.

Meanwhile, the profile acquisition unit 110, the profile correction unit 120, and the control unit 130 provided in the battery diagnosing apparatus 100 may selectively include, for example, a processor, an application-specific integrated circuit (ASIC), other chipsets, logic circuits, registers, a communication modem, and a data processing apparatus, which are well-known in the art, in order to execute various control logics performed in the present disclosure. When the control logics are implemented by software, the profile correction unit 120 may be implemented as a set of program modules. In this case, the program modules may be stored in a memory, and executed by the profile acquisition unit 110, the profile correction unit 120, and the control unit 130. The memory may be provided inside or outside the profile acquisition unit 110, the profile correction unit 120, and the control unit 130, and may be connected to the profile acquisition unit 110, the profile correction unit 120, and the control unit 130 by various well-known means.

The battery diagnosing apparatus 100 may further include the storage unit 140. The storage unit 140 may store, for example, data or programs necessary when each component of the battery diagnosing apparatus 100 performs the operation and function thereof, or data generated when the operation and function are performed. The storage unit 140 is not particularly limited in type as long as it is a well-known information storage means capable of recording, erasing, updating, and reading data. The information storage means may include, for example, a random access memory (RAM), a flash memory, a read-only memory (ROM), an electronically erasable programmable read-only memory (EEPROM), and a register. Further, the storage unit 140 may store program codes, in which processes executable by the profile acquisition unit 110, the profile correction unit 120, and the control unit 130 are defined.

The storage unit 140 may store the battery profile BP, the differential profile DP, and the corrected profile CP.

Hereinafter, descriptions will be made on an embodiment where the control unit 130 diagnoses the state of the battery.

The control unit 130 may be configured to divide the target capacity section TR into a low capacity section and a high capacity section.

According to an embodiment, the control unit 130 may bisect the target capacity section TR to distinguish between the low capacity section and the high capacity section. For example, the low capacity section and the high capacity section have the same section size (the size of capacity range). Here, the section size refers to a difference between an upper limit capacity and a lower limit capacity of a corresponding section, and is a different factor from the area of the corresponding section.

For example, it is assumed that the target capacity section TR is a capacity section of Qn to Qm. The control unit 130 may set a capacity section of Qn to (Qm-Qn)/2 as the low capacity section, and a capacity section of (Qm-Qn)/2 to Qm as the high capacity section.

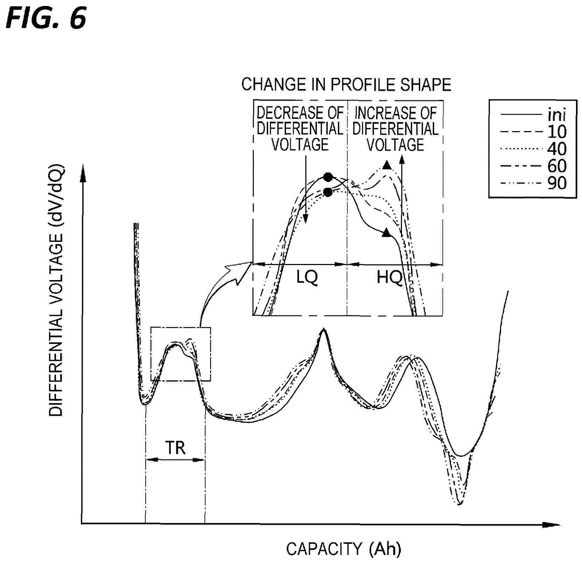

FIG. 6 is a view schematically illustrating a plurality of corrected profiles CP for a first battery according to an embodiment of the present disclosure. For example, the view of FIG. 6 represents a plurality of corrected profiles CP for a first battery that loses available lithium as a cycle progresses. For example, FIG. 6 represents corrected profiles CP corresponding to an initial cycle ini, a 10th cycle, a 40th cycle, a 60th cycle, and a 90th cycle of the first battery.

In the embodiment of FIG. 6, the target capacity section TR may be divided into a low capacity section LQ and a high capacity band HQ. Here, the low capacity section LQ and the high capacity section HQ have the same section size.

According to an embodiment, the control unit 130 may be configured to diagnose the state of the battery based on a section including a feature point with the largest corresponding differential voltage in the target capacity section TR.

Here, the feature point refers to a point included in the target capacity section TR, and indicates a point of which corresponding differential voltage is the largest.

For example, the control unit 130 may be configured to diagnose the state of the battery as the available lithium loss state, when the feature point is included in the high capacity section. For example, the control unit 130 may diagnose the state of the battery as the available lithium loss state, when the shape of the profile has changed to the extent that the feature point is present in the high capacity section due to the loss of available lithium of the battery.

In another example, when the feature point is included in the low capacity section, the control unit 130 may diagnose the state of the battery as an available lithium non-loss state. Here, the feature point gradually moves toward the side of the high capacity as the available lithium is lost, and therefore, even though the feature point is included in the low capacity section, the available lithium of the battery may be partially lost. According to an embodiment, even when the available lithium is partially lost from the initial state, the control unit 130 may diagnose the state of the battery while ignoring the extent of available lithium loss that does not change the shape of the profile.

For example, in the embodiment of FIG. 6, the feature point is included in the low capacity section LQ during the initial cycle ini, but included in the high capacity section HQ during the 60th cycle and the 90th cycle. In this way, as the cycle progresses, the highest differential voltage in the low capacity section LQ decreases, and the highest differential voltage in the high capacity section HQ increases. As a result, the shape of the profile itself may change due to the loss of available lithium. Thus, according to an embodiment, the control unit 130 may diagnose whether the available lithium of the battery has been lost, based on the section including the feature point.

The target capacity section TR is a capacity that mainly represents the state of the negative electrode of the battery. Thus, when the available lithium of the battery is lost, the shape of the profile in the target capacity section TR may change most drastically. For example, the position of the feature point with the largest differential voltage in the target capacity section TR changes most significantly.

For example, in the corrected profile CP of the battery in the beginning of life (BOL) state, the feature point is included in the low capacity section of the target capacity section TR. However, in the corrected profile CP of the battery with the significant loss of available lithium, the feature point is included in the high capacity section of the target capacity section TR. In this way, as the available lithium is lost, the feature point moves from the low capacity section to the high capacity section of the target capacity section TR. Thus, the battery diagnosing apparatus 100 may quickly diagnose the state of the battery by taking into account an abnormal behavior of the feature point due to the loss of available lithium of the battery.

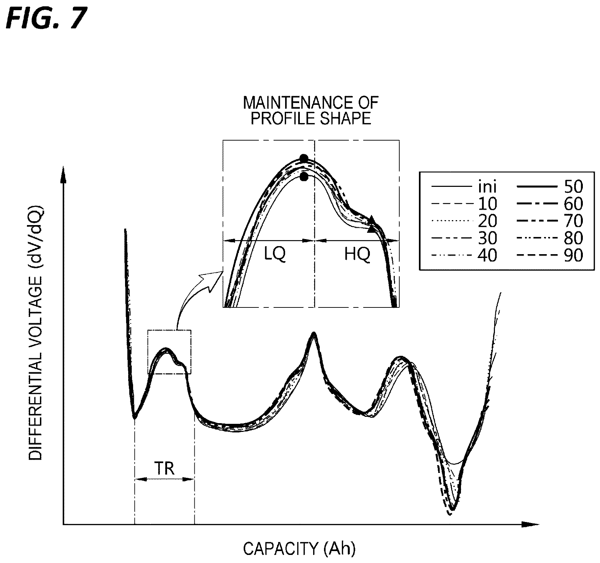

FIG. 7 is a view schematically illustrating the state of the battery corresponding to a plurality of corrected profiles CP for a second battery according to an embodiment of the present disclosure. FIG. 7 illustrates a plurality of corrected profiles CP for a second battery with a loss of positive electrode capacity. For example, FIG. 7 is a view illustrating a plurality of corrected profiles CP corresponding to an initial cycle ini, a 10th cycle, a 20th cycle, a 30th cycle, a 40th cycle, a 50th cycle, a 60th cycle, a 70th cycle, an 80th cycle, and a 90th cycle.

Unlike the embodiment of FIG. 6, the feature point included in the target capacity section TR in the embodiment of FIG. 7 remains in the low capacity section LQ even as the cycle progresses. For example, as long as the battery does not lose available lithium, the profile shape of the target capacity section TR does not change even when the battery degrades due to other causes (e.g., loss of positive electrode capacity). Thus, the battery diagnosing apparatus 100 may quickly diagnose whether the state of the battery is the available lithium loss state, based on the loss of available lithium and the abnormal behavior of the feature point.

Next, descriptions will be made on an embodiment where the control unit 130 sets the target capacity section TR.

The control unit 130 may be configured to determine, as a target peak tp, a minimum point with the smallest corresponding capacity among minimum points included in the corrected profile CP.

According to an embodiment, the corrected profile CP may include a plurality of minimum points. The control unit 130 may be configured to determine, as the target peak tp, a minimum point with the smallest corresponding capacity among the plurality of minimum points included in the corrected profile CP.

For example, in the embodiment of FIG. 5, the corrected profile CP may include a first minimum point p1, a second minimum point p2, a third minimum point p3, and a fourth minimum point p4. Since the capacity corresponding to the first minimum point p1 among the first to fourth minimum points p4 is the smallest, the control unit 130 may determine the first minimum point p1 to be the target peak tp.

The control unit 130 may be configured to set the target capacity section TR based on a target differential voltage corresponding to the target peak tp.

According to an embodiment, the control unit 130 may be configured to determine a reference point rp corresponding to the target differential voltage and closest to the target peak tp in the corrected profile CP.

In general, in the differential profile DP representing the correspondence between the capacity and the differential voltage of the battery, the differential voltage corresponding to the second minimum point p2 is smaller than the target differential voltage of the target peak tp. Thus, the reference point rp determined by the control unit 130 may be present between the target peak tp and the second minimum point p2.

Thus, the control unit 130 may be configured to set the capacity section from the target peak tp to the reference point rp as the target capacity section TR.

For example, in the embodiment of FIG. 5, the target differential voltage of the target peak tp is dV1. In the corrected profile CP, there are six points having the differential voltage of dV1, excluding the target peak tp. The control unit 130 may determine the point closest to the target peak tp among the six points, to be the reference point rp. Then, the control unit 130 may set the capacity section from the capacity of the target peak tp to the capacity of the reference point rp as the target capacity section TR.

When the differential voltage corresponding to the second minimum point p2 is larger than the target differential voltage of the target peak tp, the target capacity section TR may be set to be overly wide. Since the feature point is adjacent to the target peak tp, it may not be accurately determined whether the shape of the profile has changed, based on the overly wide target capacity section TR.

According to an embodiment, the control unit 130 may be configured such that when the differential voltage of the target peak tp is smaller than the differential voltage of the second minimum point p2 with the second smallest corresponding capacity among the plurality of minimum points, the differential voltage corresponding to the second minimum point p2 is set as the target differential voltage.

Then, the control unit 130 may be configured to determine the reference point rp that corresponds to the target differential voltage of the second minimum point p2 and is closest to the second minimum point p2 in the corrected profile CP.

According to an embodiment, the control unit 130 may determine the reference point rp between the first minimum point p1 and the second minimum point p2.

Lastly, the control unit 130 may be configured to set the capacity section from the reference point rp to the second minimum point p2 as the target capacity section TR.

According to an embodiment, the control unit 130 may set an appropriate target capacity section TR based on the capacities of the second minimum point p2 and the reference point rp. Thus, the state of the battery may be diagnosed based on the capacity section including the feature point in the target capacity section TR.

For example, unlike the embodiment of FIG. 5, when the differential voltage of the target peak tp is lower than the differential voltage of the second minimum point p2, the target capacity section TR may be set to be overly wide. In this case, since the feature point included in the target capacity section TR according to the embodiment of FIG. 5 may also change, the state of the battery may be diagnosed inaccurately. The battery diagnosing apparatus 100 according to an embodiment of the present disclosure has the advantage of accurately diagnosing the state of the battery by appropriately setting the target capacity section TR even in the exceptional situation where the differential voltage corresponding to the target peak tp is lower than the differential voltage of the second minimum point p2.

The battery diagnosing apparatus 100 according to the present disclosure may be applied to a battery management system (BMS). For example, a BMS according to the present disclosure may include the battery diagnosing apparatus 100 described above. In this configuration, at least a portion of the respective components of the battery diagnosing apparatus 100 may be implemented by complementing or adding functions of components included in well-known BMSs. For example, the profile acquisition unit 110, the profile correction unit 120, the control unit 130, and the storage unit 140 of the battery diagnosing apparatus 100 may be implemented as components of the BMS.

Further, the battery diagnosing apparatus 100 according to the present disclosure may be provided in a battery pack. For example, the battery pack according to the present disclosure may include the battery diagnosing apparatus 100 described above and one or more battery cells. Further, the battery pack may include, for example, electronic components (e.g., relays and fuses) and a case.

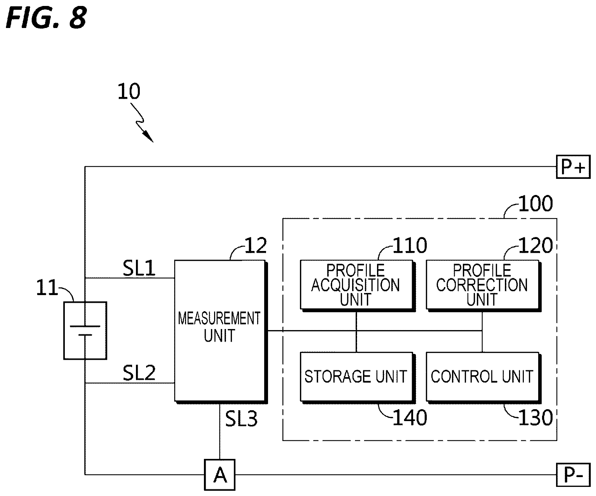

FIG. 8 is a view schematically illustrating a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measurement unit 12 may be connected to a first sensing line SL1, a second sensing line SL2, and a third sensing line SL3. For example, the measurement unit 12 may be connected to the positive electrode terminal of the battery 11 via the first sensing line SL1, and may be connected to the negative electrode terminal of the battery 11 via the second sensing line SL2. The measurement unit 12 may measure the voltage of the battery 11 based on the voltage measured in each of the first sensing line SL1 and the second sensing line SL2.

The measurement unit 12 may be connected to a current measuring unit A via the third sensing line SL3. For example, the current measuring unit A may be an ammeter or a shunt resistor capable of measuring a charging current and a discharging current of the battery 11. The measurement unit 12 may measure the charging current of the battery 11 through the third sensing line SL3 to calculate a charging amount. Further, the measurement unit 12 may measure the discharging current of the battery 11 through the third sensing line SL3 to calculate a discharging amount.

For example, the profile acquisition unit 110 may receive battery information about the voltage and the current of the battery from the measurement unit 12. Then, the profile acquisition unit 110 may generate the battery profile BP and the differential profile DP based on the battery information.

In another example, the profile acquisition unit 110 may receive the battery profile BP from the measurement unit 12. Then, the profile acquisition unit 110 may generate the differential profile DP based on the battery profile BP.

In yet another example, the profile acquisition unit 110 may receive the differential profile DP from the measurement unit 12.

An external device may be connected to the positive electrode terminal P+ and the negative electrode terminal P- of the battery pack 10. For example, the external device may be a charging device or a load. The positive electrode terminal of the battery 11, the positive electrode terminal P+ of the battery pack 10, the external device, the negative electrode terminal P- of the battery pack 10, and the negative electrode terminal of the battery 11 may be electrically connected to each other.

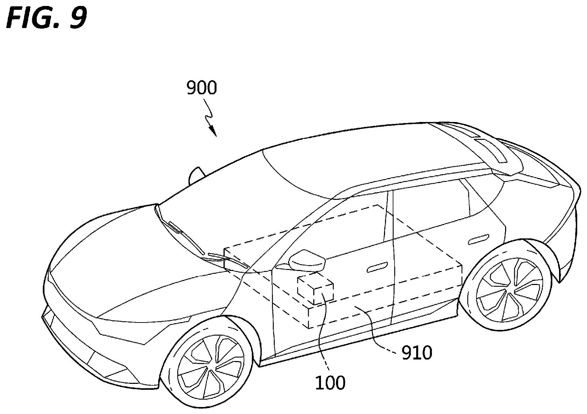

FIG. 9 is a view schematically illustrating a vehicle 900 according to another embodiment of the present disclosure.

Referring to FIG. 9, the battery pack according to an embodiment of the present disclosure may be included in the vehicle 900 such as an electric vehicle (EV) or a hybrid vehicle (HV). A battery pack 910 may supply a power to a motor via an inverter provided in the vehicle 900, to drive the vehicle 900. Here, the battery pack 910 may include the battery diagnosing apparatus 100. For example, the vehicle 900 may include the battery diagnosing apparatus 100. In this case, the battery diagnosing apparatus 100 may be an on-board apparatus included in the vehicle 900.

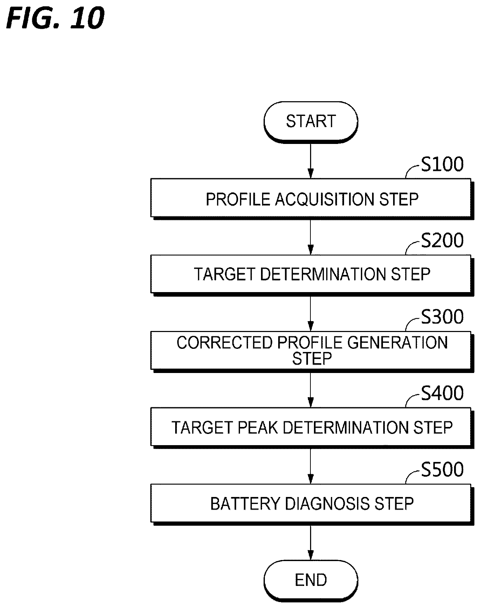

FIG. 10 is a view schematically illustrating a battery diagnosing method according to another embodiment of the present disclosure.

Referring to FIG. 10, the battery diagnosing method may include a profile acquisition step S100, a target determination step S200, a corrected profile generation step S300, a target peak determination step S400, and a battery diagnosis step S500.

Each step of the battery diagnosing method may be performed by the battery diagnosing apparatus 100.

The profile acquisition step S100 is a step of acquiring the differential profile DP representing the correspondence between the capacity and the differential voltage of the battery, and may be performed by the profile acquisition unit 110.

For example, the profile acquisition unit 110 may directly receive the differential profile DP of the battery from the outside. For example, the profile acquisition unit 110 may acquire the differential profile DP by being connected to the outside via a wired and/or wireless network to receive the differential profile DP.

In another example, the profile acquisition unit 110 may directly receive the battery profile BP of the battery from the outside. Then, the profile acquisition unit 110 may generate the differential profile DP based on the battery profile BP. According to an embodiment, the profile acquisition unit 110 may be connected to the outside in the wired and/or wireless manner to receive the battery profile BP, and directly generate the differential profile DP from the received battery profile BP, to acquire the differential profile DP.

In yet another example, the profile acquisition unit 110 may receive battery information about the voltage and the capacity of the battery. Then, the profile acquisition unit 110 may generate the battery profile BP based on the received battery information, and may generate the differential profile DP based on the generated battery profile BP. The profile acquisition unit 110 may acquire the differential profile DP by directly generating the differential profile DP based on the battery information.

The target determination step S200 is a step of determining the target C-rate corresponding to the differential profile DP, and may be performed by the profile correction unit 120.

For example, the profile correction unit 120 may receive the differential profile DP and information about the C-rate from the profile acquisition unit 110. Then, the profile correction unit 120 may determine the C-rate corresponding to the differential profile DP to be the target C-rate.

The corrected profile generation step S300 is a step of generating the corrected profile CP by correcting the differential profile DP based on an overvoltage profile corresponding to the target C-rate, and may be performed by the profile correction unit 120.

Then, the profile correction unit 120 may be configured to select the overvoltage profile corresponding to the target C-rate from a plurality of pre-stored overvoltage profiles. The profile correction unit 120 may be configured to calculate the difference between the differential profile DP and the overvoltage profile to generate the corrected profile CP.

For example, the profile correction unit 120 may calculate a differential capacity difference for each voltage between the differential profile DP and the overvoltage profile, to generate the corrected profile CP.

The target peak determination step S400 is a step of determining, as the target peak tp, a minimum point with the smallest corresponding capacity among minimum points included in the corrected profile CP, and setting the target capacity section TR based on the target differential voltage corresponding to the target peak tp, and may be performed by the control unit 130.

For example, the control unit 130 may be configured to determine, as the target peak tp, a minimum point with the smallest corresponding capacity among a plurality of minimum points included in the corrected profile CP. In the embodiment of FIG. 5, the corrected profile CP may include a first minimum point p1, a second minimum point p2, a third minimum point p3, and a fourth minimum point p4. Since the capacity corresponding to the first minimum point p1 is the smallest among the first to fourth minimum points p4, the control unit 130 may determine the first minimum point p1 to be the target peak tp. Further, the control unit 130 may be configured to set the target capacity section TR based on the target differential voltage corresponding to the target peak tp.

The battery diagnosis step S500 is a step of diagnosing the state of the battery based on the shape of the target capacity section TR of the corrected profile CP, and may be performed by the control unit 130.

The control unit 130 may diagnose the state of the battery based on whether the shape of the target capacity section TR has changed. For example, the control unit 130 may determine whether the shape of the target capacity section TR has changed, and diagnose the state of the battery based on the determination result.

For example, the control unit 130 may diagnose whether the available lithium of the battery has been lost. For example, when it is determined that the shape of the target capacity section TR has changed, the control unit 130 may diagnose the state of the battery as the available lithium loss state.

The embodiments of the present disclosure described above are not only implemented by an apparatus and method, but may also be implemented by programs implementing functions corresponding to the components of the embodiments of the present disclosure or a recording medium that stores the programs. This implementation may readily be achieved by one skilled in the art to which the present disclosure belongs, from the descriptions of the embodiments above.

While the present disclosure has been described using limited embodiments and drawings, the present disclosure is not limited thereto, and it may be appreciated that various modifications and changes may be made by those having ordinary skill in the art of the present disclosure within the technical idea of the present disclosure and the equitable scope of the claims set forth below.

Further, since various substitutions, modifications, and changes may be made by those having ordinary skill in the art of the present disclosure within the scope that does not depart from the technical idea of the present disclosure, the present disclosure described above is not limited by the foregoing embodiments and the accompanying drawings, but all or portions of the embodiments may be selectively combined to implement various modifications.

### (Description of Symbols)

10: battery pack
11: battery
12: measurement unit
100: battery diagnosing apparatus
110: profile acquisition unit
120: profile correction unit
130: control unit
140: storage unit
900: vehicle
910: battery pack

## Claims

1. A battery diagnosing apparatus comprising:
a profile acquisition unit configured to acquire a differential profile representing a correspondence between a capacity and a differential voltage of a battery;
a profile correction unit configured to determine a target C-rate (current rate) corresponding to the differential profile, and correct the differential profile based on an overvoltage profile corresponding to the target C-rate, thereby generating a corrected profile; and
a control unit configured to diagnose a state of the battery based on a shape of a target capacity section of the corrected profile.

2. The battery diagnosing apparatus according to claim 1, wherein the control unit is configured to determine, as a target peak, a minimum point with a smallest corresponding capacity among a plurality of minimum points included in the corrected profile, and set the target capacity section based on a target differential voltage corresponding to the target peak.

3. The battery diagnosing apparatus according to claim 2, wherein the control unit is configured to determine a reference point corresponding to the target differential voltage and closest to the target peak in the corrected profile, and set a capacity section from the target peak to the reference point as the target capacity section TR.

4. The battery diagnosing apparatus according to claim 2, wherein the control unit is configured such that when a differential capacity of the target peak is smaller than a differential capacity of a second minimum point with a second smallest corresponding capacity among the plurality of minimum points, a differential voltage corresponding to the second minimum point is set as the target differential voltage.

5. The battery diagnosing apparatus according to claim 4, wherein the control unit is configured to determine a reference point corresponding to the target differential voltage and closest to the second minimum point in the corrected profile, and set a capacity section from the reference point to the second minimum point as the target capacity section.

6. The battery diagnosing apparatus according to claim 1, wherein the control unit is configured to divide the target capacity section into a low capacity section and a high capacity section, and diagnose the state of the battery based on a section including a feature point with a largest corresponding differential voltage in the target capacity section.

7. The battery diagnosing apparatus according to claim 6, wherein the control unit is configured such that when the feature point is included in the high capacity section, the state of the battery is diagnosed as an available lithium loss state.

8. The battery diagnosing apparatus according to claim 1, wherein the profile correction unit is configured to calculate a difference between the differential profile and the overvoltage profile to generate the corrected profile.

9. The battery diagnosing apparatus according to claim 1, wherein the overvoltage profile is pre-stored for each of a plurality of C-rates, and
the profile correction unit is configured to select the overvoltage profile corresponding to the target C-rate from a plurality of pre-stored overvoltage profiles.

10. The battery diagnosing apparatus according to claim 1, wherein the overvoltage profile is preset based on a reference differential profile of a reference battery for a reference C-rate and a target differential profile of the reference battery for the target C-rate.

11. The battery diagnosing apparatus according to claim 10, wherein the overvoltage profile is preset to represent a difference between the reference differential profile and the target differential profile.

12. A battery pack comprising the battery diagnosing apparatus according to any one of claims 1 to 11.

13. A vehicle comprising the battery diagnosing apparatus according to any one of claims 1 to 11.

14. A battery diagnosing method comprising:
a profile acquisition step of acquiring a differential profile representing a correspondence between a capacity and a differential voltage of a battery;
a target determination step of determining a target C-rate corresponding to the differential profile;
a corrected profile generation step of correcting the differential profile based on an overvoltage profile corresponding to the target C-rate to generate a corrected profile; and
a battery diagnosis step of diagnosing a state of the battery based on a shape of a target capacity section of the corrected profile.

15. A non-transitory computer-readable storage medium having stored therein a program for performing a battery diagnosing method, the method comprising:
a profile acquisition step of acquiring a differential profile representing a correspondence between a capacity and a differential voltage of a battery;
a target determination step of determining a target C-rate corresponding to the differential profile;
a corrected profile generation step of correcting the differential profile based on an overvoltage profile corresponding to the target C-rate to generate a corrected profile; and
a battery diagnosis step of diagnosing a state of the battery based on a shape of a target capacity section of the corrected profile.
